# EUROPEAN PATENT SPECIFICATION

(11) **EP 4 589 736 B1**
(45) Date of publication and mention of the grant of the patent: **21.10.2026**
(21) Application number: 24223404.5
(22) Date of filing: 27.12.2024
(51) Int. Cl.: H01M 10/613, H01M 10/627, H01M 10/6563, H01M 10/6566

(54) **ENERGY STORAGE CABINET, AND CABINET-TYPE ENERGY STORAGE DEVICE**
ENERGIESPEICHERSCHRANK UND SCHRANKARTIGE ENERGIESPEICHERVORRICHTUNG
ARMOIRE DE STOCKAGE D'ÉNERGIE ET DISPOSITIF DE STOCKAGE D'ÉNERGIE DE TYPE ARMOIRE

(30) Priority: 29.12.2023 CN 202311866839
(43) Date of publication of application: 23.07.2025
(73) Proprietor: Hithium Tech HK Limited, Hong Kong (HK)
(72) Inventor: HONG, Chunsheng, Xiamen, Fujian, 361100 (CN); CHEN, Zhensheng, Xiamen, Fujian, 361100 (CN); HUANG, Yingxiong, Xiamen, Fujian, 361100 (CN)
(74) Representative: Manitz Finsterwald Patent- und Rechtsanwaltspartnerschaft mbB

(56) References cited:
- EP-A1- 3 893 616
- CN-A- 116 759 691
- US-A1- 2023 057 893

## Description

### RELATED APPLICATIONS

This application claims priority under 35 U.S.C. § 119(a) to Chinese Patent Application No. 202311866839.9, filed December 29, 2023.

### TECHNICAL FIELD

This disclosure relates to the field of energy storage technology, and in particular, to an energy storage cabinet and a cabinet-type energy storage device.

### BACKGROUND

A cabinet-type energy storage device is an apparatus used to store electrical energy. The cabinet-type energy storage device usually includes a cabinet body, and energy storage batteries, an energy storage converter, etc. installed in the cabinet body. The energy storage batteries and the energy storage converter are usually located in two different chambers in the cabinet body to avoid the generated heat affecting each other. For the chamber where the energy storage converter is placed, a front side plate and a back side plate of the cabinet body are provided with an air inlet and an air outlet respectively. The air inlet and the air outlet are in communication with the chamber. The cold air is blown into the air inlet to cool the energy storage converter, and the cold air is heated into hot air and flows out of the chamber from the air outlet to ensure the operation stability of the energy storage converter. CN 116 759 691 A discloses an energy storage cabinet and an energy storage system. US 2023/057893 A1 discloses a heat dissipation cabinet including a cabinet body, a cabinet door, and a baffle. EP 3 893 616 A1 discloses a cabinet and a flexible air duct system.

### SUMMARY

The present invention is set out in the appended claims. In a first aspect, an energy storage cabinet is provided in the application. The energy storage cabinet includes a cabinet body, a baffle and an energy storage converter. A partition is provided in the cabinet body. An internal space of the cabinet body includes a battery chamber and a converter chamber separated by the partition. Side plates of the cabinet body has an air inlet and an air outlet are in communication with the converter chamber, respectively. The baffle is located in the converter chamber and separates the converter chamber into a cold air cavity and a hot air cavity. The cold air cavity is in communication with the air inlet, and the hot air cavity is in communication with the air outlet. The energy storage converter is located in the converter chamber and has a heat-dissipation air duct. The heat-dissipation air duct includes an air inlet port located at an air inlet end of the energy storage converter and an air outlet port located at an air outlet end of the energy storage converter. The air inlet port is in communication with the cold air cavity, and the air outlet port is in communication with the hot air cavity. The baffle has an avoidance opening, and an edge of the avoidance opening abuts against a side wall of the air outlet end of the energy storage converter. The baffle comprises a windshield part and a guide part. The avoidance opening is located in the windshield part, the guide part is connected with the windshield part, and an edge of the guide part away from the windshield part faces towards the air outlet and abuts against one of the side plates of the cabinet body having the air outlet.

In a second aspect, a cabinet-type energy storage device is provided in the application. The cabinet-type energy storage device includes the energy storage cabinet mentioned in the first aspect and en energy storage unit. The energy storage cabinet has a storage rack in the battery chamber. The energy storage unit located on the storage rack and electrically connected with the energy storage converter.

In the implementation of this application, combined with the energy storage cabinet mentioned above, the stability and safety of the operation of the cabinet-type energy storage device can be effectively ensured.

It may be understood that, the general description above and the detailed description below are illustrative and explanatory only and do not limit this application.

### BRIEF DESCRIPTION OF THE DRAWINGS

The foregoing and other features and advantages of the present application will become more apparent by describing in detail exemplary implementations thereof with reference to the accompanying drawings.
FIG. 1 is a schematic structural diagram of a household energy storage system according to an exemplary embodiment.
FIG.2 is a schematic front view of a cabinet-type energy storage device according to an exemplary embodiment.
FIG.3 is a schematic diagram showing an internal structure of the cabinet-type energy storage device according to the exemplary embodiment.
FIG.4 is an axonometric view showing an internal structure of an energy storage cabinet according to related art.
FIG.5 is a simulation diagram of air flow in a converter chamber of an energy storage cabinet according to related art.
FIG.6 is a schematic front view showing an internal structure of the energy storage cabinet according to the exemplary embodiment.
FIG.7 is a schematic, front axonometric view showing an internal structure of the energy storage cabinet according to the exemplary embodiment.
FIG.8 is a schematic, rear axonometric view showing an internal structure of the energy storage cabinet according to the exemplary embodiment.
FIG.9 is a simulation diagram of air flow in a converter chamber of the energy storage cabinet according to the exemplary embodiment.
FIG.10 is a schematic side view showing an internal structure of a cabinet-type energy storage device according to another exemplary embodiment.
FIG.11 is a schematic side view showing an internal structure of a cabinet-type energy storage device according to yet another exemplary embodiment.
FIG.12 is a schematic rear axonometric view of a partition according to the exemplary embodiment.
FIG.13 is an enlarged structural schematic diagram of the partition shown in FIG.12 in an area A.
FIG.14 is an enlarged structural schematic diagram of the partition shown in FIG.12 in an area B.

Description of reference numerals of the accompanying drawings:
100, energy storage apparatus; 200, electric energy conversion apparatus; 300, user load; 10, cabinet-type energy storage device; 1, energy storage cabinet; 2, energy storage unit; 11, cabinet body; 12, partition; 13, baffle; 14, energy storage converter; 15, liquid cooling unit; 16. high voltage box; 17,circuit breaker; 18, uninterruptible power source; 19, junction box; 20, axial flow fan; 111, front side plate; 112, back side plate; 113, top plate; 114, battery chamber; 115, converter chamber; 116, liquid cooling chamber; 1111, air inlet; 1112, left cabinet door; 1113, right cabinet door; 1121, air outlet; 1141, liquid cooling pipeline; 1151, cold air cavity; 1152, hot air cavity; 1153, support frame; 1154, drainage hole; 131, avoidance opening; 132, windshield part; 133, guide part; 134, first turning edge; 135, second turning edge; 136, gap; 141, air inlet port; 142, air outlet port

### DETAILED DESCRIPTION

Example implementations will now be described more fully with reference to the accompanying drawings. However, the example implementations may be implemented in various forms and may not be construed as being limited to the implementations set forth herein; rather, these implementations are provided so that the present application will be thorough and complete, and will fully convey the concepts of the example implementations in those skilled in the art. The same reference signs in the drawings denote the same or similar structures, and thus their detailed descriptions will be omitted.

Since energy required by people has strong timeliness and spatiality, in order to use energy in a reasonable manner and improve energy utilization, a medium or an apparatus is required to store energy in the same energy form or in another energy form converted and then to release energy in a specific energy form based on requirements of future applications.

The current green energy mainly includes light energy, wind energy, etc. However, there are common problems such as light energy and wind energy with strong intermittency and large volatility, which will cause the voltage of the green power to be unstable (the power is not enough at the peak of the power consumption and too much at the valley of the power consumption), and the unstable voltage will cause loss of the power, so the problem of "abandoning wind and light" may be caused due to insufficient power demand or insufficient power grid acceptance capacity.

In order to solve the problem of insufficient power demand or insufficient power grid acceptance capacity, an energy storage apparatus is needed. That is, electrical energy is converted into other energy forms by physical or chemical means and then stored in the energy storage apparatus. The energy stored in the energy storage apparatus is converted into electrical energy and then released when needed. In brief, the energy storage apparatus is similar to a large "power bank", which stores electrical energy when light energy and wind energy are sufficient and releases stored electrical energy when needed.

The current energy storage (i.e. energy storage) has wide application scenarios including power generation side energy storage, power grid side energy storage, renewable energy gridconnected energy storage and user side energy storage, etc. Corresponding types of energy storage apparatus include:
(1) Large-scale energy storage containers used in power grid side energy storage scenarios and the like, which can be used as high-quality active and reactive power regulation power sources in the power grid to achieve load matching of electric energy in time and space, enhance renewable energy consumption capabilities, and it is great significance in power grid system backup, alleviating peak load power supply pressure, and peak and frequency regulation;
(2) Small and medium-sized cabinet-type energy storage devices and the like, used in industrial and commercial energy storage scenarios (banks, shopping malls, etc.) at the user side, and small household energy storage boxes used in home energy storage scenarios at the user side, the main operating mode of which is "peak shaving and valley filling". Since there is a large price difference in electricity bills at peak and valley locations according to electricity-consumption demand, after users have energy storage apparatus, in order to reduce costs, during the low electricity price period, energy storage cabinets/boxes are usually charged. During the peak electricity price period, the electricity in the energy storage apparatus is discharged for use to achieve the purpose of saving electricity bills. In addition, in remote areas, as well as areas with high incidence of natural disasters such as earthquakes and hurricanes, the existence of household energy storage apparatus is equivalent to users providing backup power for themselves and the power grid, eliminating the inconvenience caused by frequent power outages due to disasters or other reason.

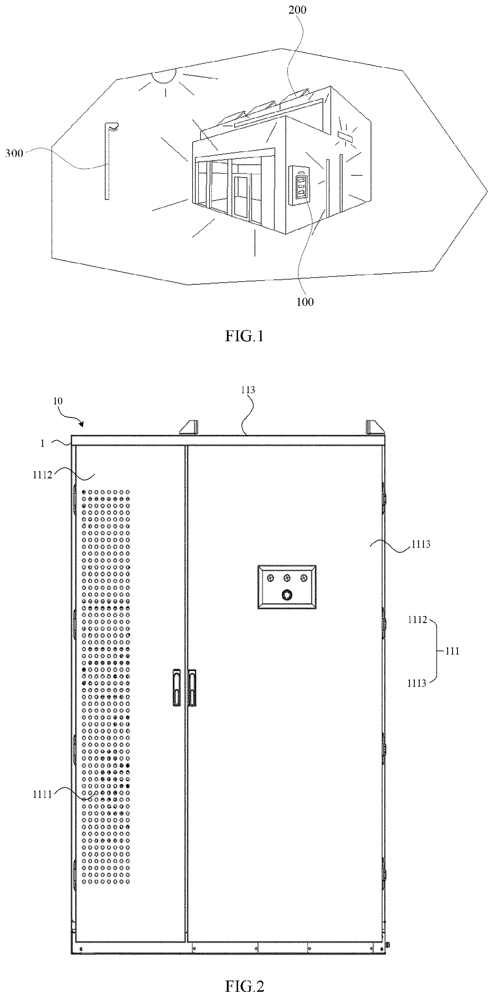

Taking the household energy storage scenario in user side energy storage as an example, FIG. 1 shows a household energy storage system. The household energy storage system includes an energy storage apparatus 100 and a power conversion apparatus 200 (such as a photovoltaic plate). User loads 300 (such as street lights, household appliances, etc.) are provided. The energy storage apparatus 100 is a small-sized cabinet-type energy storage device. Specifically, the electric energy conversion apparatus 200 can convert solar energy into electric energy during low electricity price period, store it through the energy storage apparatus 100, and then supply it to the user load 300 for use during the peak electricity price period, or supply the user load 300 for use when the power grid is out of power/power failure.

In combination with the above mentioned energy storage through physical or electrochemical means, taking an electrochemical energy storage as an example, the energy storage apparatus 100 includes at least one chemical battery, and uses the chemical elements in the chemical battery as the energy storage medium to achieve the process of charge and discharge through the chemical reaction or change of the energy storage medium. In short, the electric energy generated by light energy and wind energy is stored in at least one group of chemical batteries through the chemical reaction or change of the energy storage medium, and when the use of external energy reaches its peak, the electric energy stored in the at least one group of chemical batteries is released for use through the chemical reaction or change of the energy storage medium or is transferred to the place where the electricity is in short supply.

An energy storage apparatus 100 is provided in accordance with an exemplary embodiment. The energy storage apparatus 100 can be an energy storage electric box, a cabinet-type energy storage device 10, etc., comprising single batteries. The single battery can be selected from a group consisting of a lithium-ion battery, a lithium-sulfur battery, a sodium-lithium-ion battery, a sodium-ion battery, a magnesium-ion battery, etc. A shape of the single battery can be selected from the group consisting of a cylinder, a flat body, a cuboid, etc., not limited in the embodiments of this application.

Next, the cabinet-type energy storage device 10 is taken as an example of the energy storage device 100 to explain in detail.

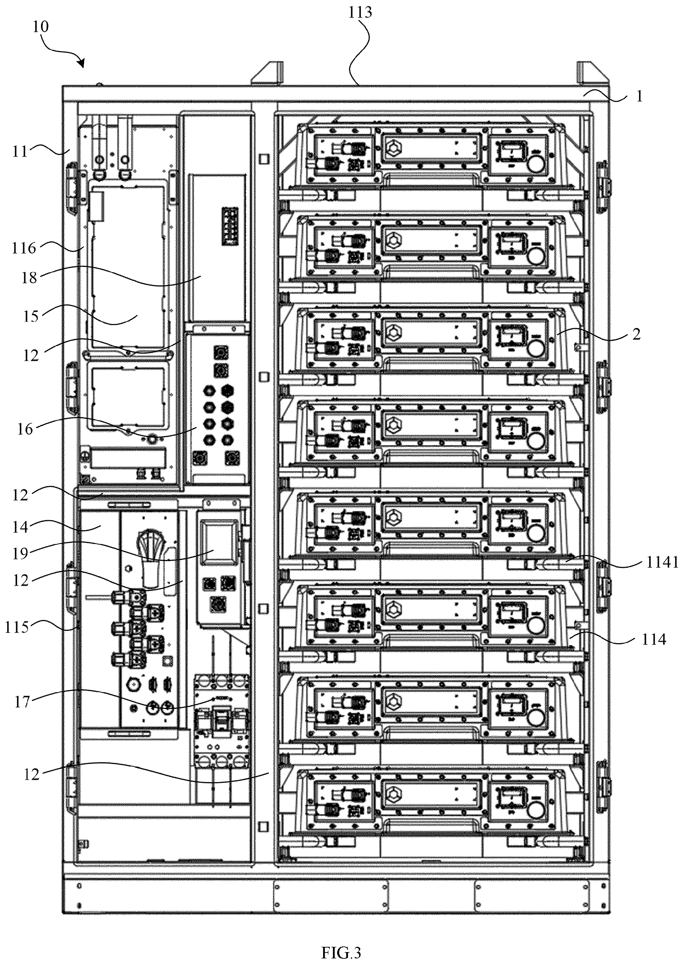

FIG.2 shows a structural diagram of the cabinet-type energy storage device 10 according to an embodiment of this application, and FIG.3 shows an internal structural diagram of the cabinet-type energy storage device 10 according to the embodiment of this application. As illustrated in FIG.2 and FIG.3, the cabinet-type energy storage device 10 includes an energy storage cabinet 1 and energy storage units 2. The energy storage units 2 are arranged in the energy storage cabinet 1.

As illustrated in FIG.3, the energy storage cabinet 1 includes a cabinet body 11 and an energy storage converter 14. The cabinet body 11 is provided with a partition 12. The partition 12 divides the internal space of the cabinet body 11 into a battery chamber 114 and a converter chamber 115. The energy storage units 2 are located in battery chamber 114, and the energy storage converter 14 is located in the converter chamber 115. The energy storage converter 14 is electrically connected with the energy storage unit 2. Thus, after the energy storage converter 14 is connected to the external power grid and the electrical load, the external power grid can charge the energy storage unit 2 through the AC/DC conversion of the energy storage converter 14, and the power supply of the energy storage unit 2 to the electrical load can be realized through the DC/AC conversion of the energy storage converter 14.

The energy storage unit 2 can be a single battery, or can be selected from a group consisting of a battery module, an energy storage box, a battery pack, etc., each of which includes single batteries. A storage rack is arranged in the battery chamber 114, and the energy storage units 2 are placed on the storage rack. The storage rack can be a multi-layer structure, so that it is convenient to place multiple energy storage units 2 into the battery chamber 114 of the energy storage cabinet 1 to improve the energy storage capacity of cabinet-type energy storage device 10.

Alternatively, the top of the cabinet body 11 is provided with a plurality of hanging ears, so as to facilitate the lifting and handling of the energy storage cabinet 1 by connecting a hanging rope to the hanging ears. A door of the cabinet body 11 is provided with an indicator light and other warning devices to identify the working state (such as charging state and discharging state) of the energy storage unit 2 placed in the battery chamber 114 of the cabinet body 11.

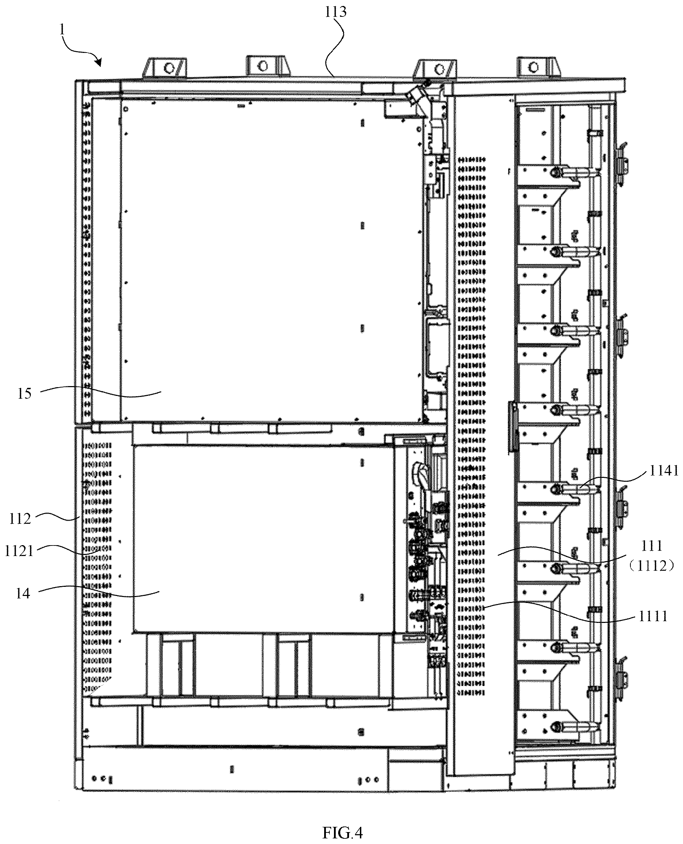

When the energy storage converter 14 realizes the AC/DC conversion or the DC/AC conversion, heat will be inevitably generated, and the heat will gather in the converter chamber 115 of the cabinet body 11, which is easy to cause the high ambient temperature of the energy storage converter 14, affecting the stability and safety of the operation of the energy storage converter 14. In related art, in order to cool down the converter chamber 115, as shown in FIG.4, an air inlet 1111 and an air outlet 1121 in communication with the converter chamber 115 are defined in a front side plate 111 and a back side plate 112 of the cabinet body 11 respectively, to ensure that the cold air outside the cabinet body 11 enters the converter chamber 115 from the air inlet 1111 of the front side plate 111. The cold air exchanges heat with the energy storage converter 14, and then flows out of the converter chamber 115 from the air outlet 1121 of the back side plate 112, to ensure that the energy storage converter 14 operates at a lower ambient temperature, so as to ensure the stability and safety of the operation of the energy storage converter 14.

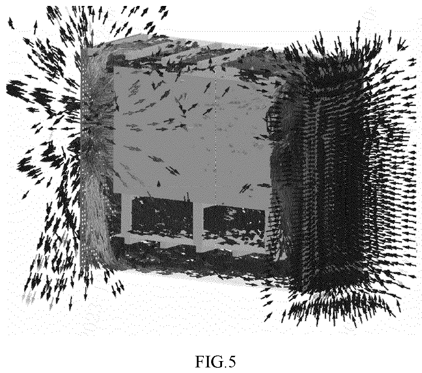

However, for the case that air holes are only defined in the front side plate 111 and the back side plate 112 of the cabinet body 11, Our technical personnel found, after careful study, that the heat-dissipation effect to the energy storage converter 14 is reduce. The reason also found by our technical personnel is like that. After the cold air enters the converter chamber 115 from the air hole in the front side plate 111 and exchanges heat to become hot air. When the hot air flows out of the converter chamber 115 from the air hole in the back side plate 112, due to the obstruction of the back side plate 112, part of the hot air flows back to the gap between an inner-wall of the energy storage converter 14 and an inner-wall of the inner wall of the converter 115, thus reducing the intake of cold air. FIG.5 shows the simulation diagram of hot air flow after heat exchange with the energy storage converter 14, and an inlet air volume and an outlet air volume are 4705m³/h and 4887m³/h, respectively.

An energy storage cabinet 1 with a baffle 13 is provided according to an embodiment of this application. Based on baffle 13, the converter chamber 115 in the cabinet body 11 is separated into a cold air cavity 1151 and a hot air cavity 1152, so as to avoid the hot air reflux after heat exchange with the energy storage converter 14 under the obstruction of baffle 13, ensuring the heat-dissipation effect of the energy storage converter 14, and thus ensuring the stability and safety of the operation of the energy storage converter14. Thus, the stability and safety of the operation of the cabinet-type energy storage device 10 are ensured for the cabinet-type energy storage device 10 including the energy storage cabinet 1.

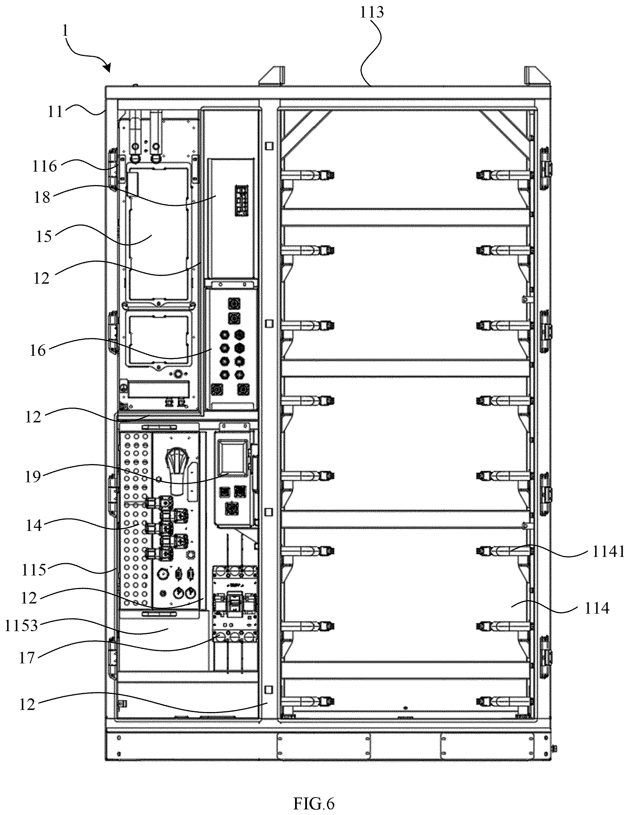

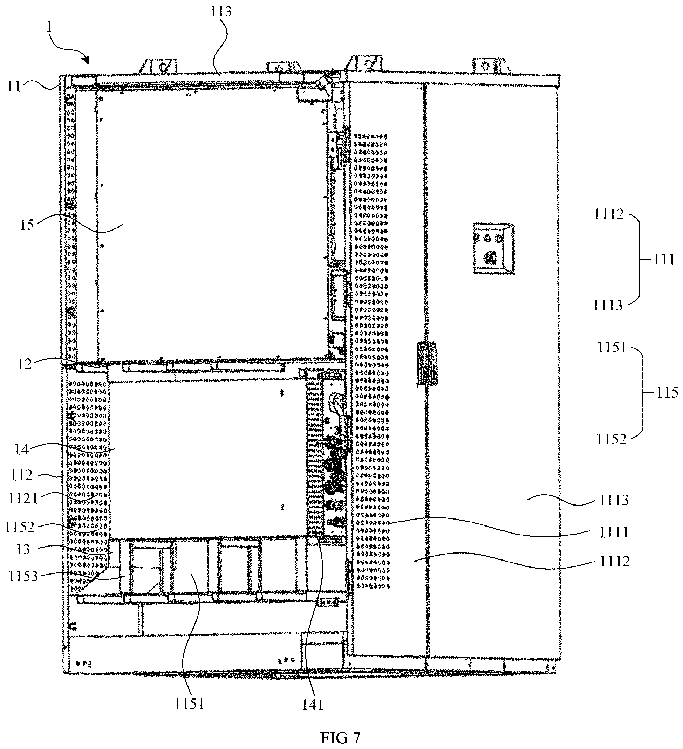

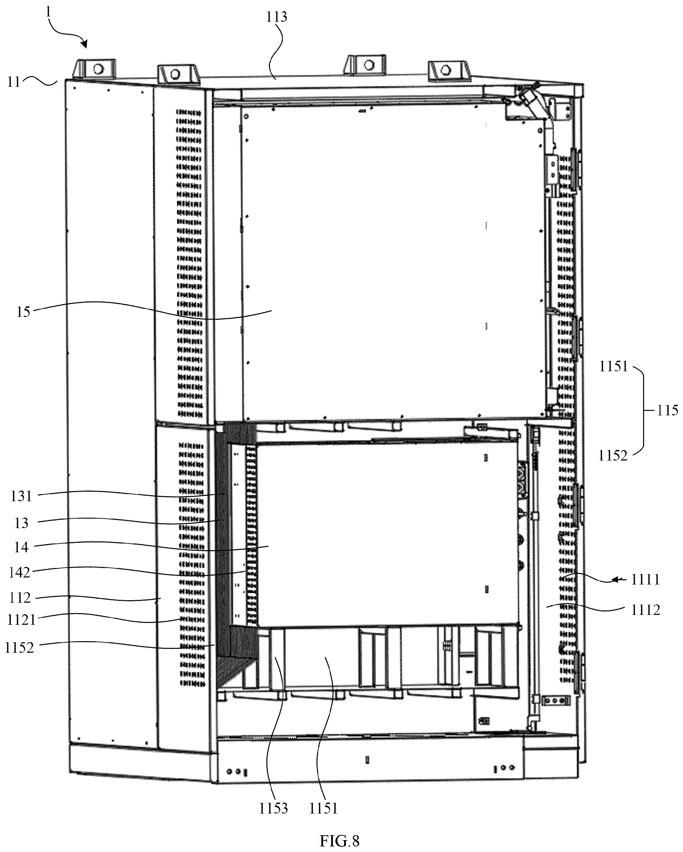

FIG.6 is a front view showing the internal structure of an energy storage cabinet 1 provided by the embodiment of this application, FIG.7 is a front axonometric view showing an internal structure of the energy storage cabinet 1 according to the embodiment of this application, and FIG.8 is a rear axonometric view showing the internal structure diagram of the energy storage cabinet 1 according to the embodiment of this application. As shown in FIG.6, FIG.7 and FIG.8, the energy storage cabinet 1 includes a cabinet body 11, a baffle 13 and an energy storage converter 14. A partition 12 is provided in the cabinet body 11. An internal space of the cabinet body 11 includes a battery chamber 114 and a converter chamber 115 separated by the partition 12. Side plates of the cabinet body 11 (the front side plate 111 and the back side plate 112) has an air inlet 1111 and an air outlet 1121 communicated with the converter chamber 115. The baffle 13 is located in the converter chamber 115 and separates the converter chamber 115 into a cold air cavity 1151 and a hot air cavity 1152. The cold air cavity 1151 is in communication with the air inlet 1111, and the hot air cavity 1152 is in communication with the air outlet 1121. The energy storage converter 14 is located in the converter chamber 115 and has a heat-dissipation air duct. The heat-dissipation air duct includes an air inlet port 141 located at an air inlet end of the energy storage converter 14 and an air outlet port 142 located at an air outlet end of the energy storage converter 14. The air inlet port 141 is in communication with the cold air cavity 1151, and the air outlet port 142 is in communication with the hot air cavity 1152.

In the implementation of this application, by setting the baffle 13 in the converter chamber 115, the converter chamber 115 is divided into the cold air cavity 1151 and the hot air cavity 1152 based on the air outlet port 142 of the energy storage converter 14, so that the cold air enters the cold air cavity 1151 from the air inlet 1111, then enters the heat-dissipation duct of the energy storage converter 14 from the air inlet port 141 for heat exchange. The hot air is got after heat exchange and directly enters the hot air cavity 1152 from the air outlet port 142, and then directly flows out of the converter chamber115 from the air outlet 1121, thereby avoiding the backflow of hot air and ensuring the heat-dissipation effect of the energy storage converter 14. Thus, it ensures that the energy storage converter 14 can operate at a lower ambient temperature, so as to improve the stability and safety of the operation of the energy storage converter 14. In addition, the heat-dissipation effect of the energy storage converter 14 can be improved only by setting the baffle 13 in the converter chamber 115, which effectively simplifies the structural adjustment in the converter chamber 115, and facilitates the maintenance of the energy storage cabinet 1 in the later period.

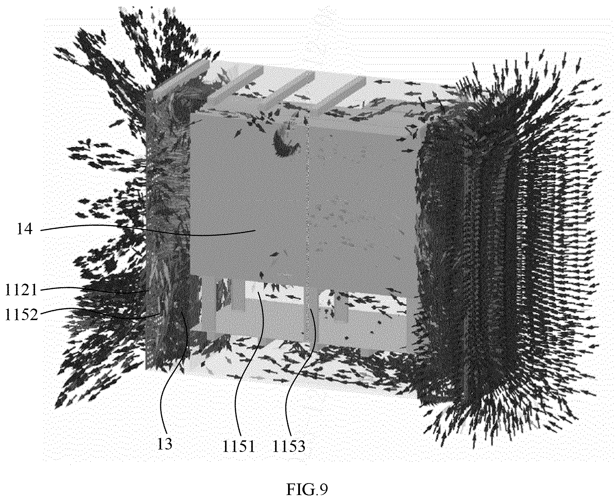

When the baffle 13 is installed in the converter chamber 115, FIG.9 shows the simulation diagram of hot air flow after heat exchange with the energy storage converter 14, and an inlet air volume and an outlet air volume are 18418m³/h and 18616m³/h, respectively. Compared with the situation where the baffle 13 is not installed in the converter chamber 115, the air volume is nearly 3.5 times higher. Thus, the heat-dissipation effect of the energy storage converter 14 can be effectively guaranteed.

The cabinet body 11 can be a structure with internal space cooperatively defined by a bottom plate, a top plate 113 and side plates, as shown in FIG.7 or FIG.8. The side plates can include the front side plate 111, the back side plate 112, a left plate (not shown) and the right plate (not shown). The front side plate 111 is divided into a left cabinet door 1112 and a right cabinet door 1113. For example, the left cabinet door 1112 can be taken as the front side plate 111 of the converter chamber 115, and the right cabinet door 1113 can be taken as the front side plate 111 of the battery chamber 114. At this time, combined with the above mentioned hanging ear, indicator light, air inlet 1111 and air outlet 1121, as shown in FIG.7 and FIG.8, it can be that the hanging ear is set on the top plate 113, the indicator light is set on the right cabinet door 1113, the air inlet 1111 is set in the left cabinet door 1112, and the air outlet 1121 is set in the back side plate 112.

A plurality of partitions 12 can be arranged in the cabinet body 11 to separate the internal space of the cabinet body 11 into multiple chambers. For example, as shown in FIG.6, two partitions 12 are provided in the cabinet body 11 to define the battery chamber 114 and the converter chamber 115 in the internal space of the cabinet body 11. In addition, in addition to the battery chamber 114 and the converter chamber 115, the internal space of the cabinet body 11 further includes a first electrical chamber separated by another partition 12. At this time, as shown in FIG.6, the energy storage cabinet 1 further includes a high voltage box 16 arranged in the first electrical chamber, and the high voltage box 16 is electrically connected with the energy storage converter 14. The high voltage box 16 is configured for electrical connection with the energy storage unit 2 in the battery chamber 114.

Alternatively, the internal space of the cabinet body 11 can also include a second electrical chamber separated by another partition 12. At this time, as shown in FIG.6, the energy storage cabinet 1 further includes a circuit breaker 17 arranged in the second electrical chamber. The circuit breaker 17 is connected in series between the external power grid and the energy storage converter 14 to protect the energy storage converter 14 through circuit breaker 17, thereby avoiding damage to the energy storage converter 14 when the external power grid fails.

Alternatively, the internal space of the cabinet body 11 may also include a third electrical chamber separated by another partition 12. At this time, as shown in FIG.6, the energy storage cabinet 1 further includes an uninterruptible power source 18 arranged in the third electrical chamber, while the energy storage cabinet 1 further includes a junction box 19 arranged in the second electrical chamber. The junction box 19is electrically connected with the uninterruptible power source 18 and the external power grid.

Alternatively, as shown in FIG.6, the internal space of the cabinet body 11 can also include a liquid cooling chamber 116 separated by another partition 12. At this time, the energy storage cabinet 1 further includes a liquid cooling unit 15 and a liquid cooling pipeline 1141. The liquid cooling unit 15 is located in the liquid cooling chamber 116. The liquid cooling pipeline 1141 is located in the battery chamber 114 and is in communication with the liquid cooling unit 15.

The liquid cooling unit 15 is electrically connected with the junction box 19 mentioned above to operate when the liquid cooling unit 15 is energized, and the energy storage unit 2 in the battery chamber 114 is cooled through the liquid cooling pipeline 1141. The liquid cooling pipeline 1141 can include a plurality of branch pipelines in parallel. Each branch pipeline corresponds to an energy storage unit 2 to realize the effective heat-dissipation of the energy storage unit 2 on each storage rack.

In the implementation of this application, when the energy storage converter 14 is assembled in the converter chamber 115, the energy storage converter 14 can be directly supported on the bottom of the converter chamber 115 and be placed in the middle. The energy storage converter 14 can also be supported on the bottom of the converter chamber 115 and abut against one side wall of the converter chamber 115. Certainly, a support frame 1153 can also be arranged in the converter chamber 115, and the energy storage converter 14 can be supported on the support frame 1153 and be placed in the middle, alternatively, as shown in FIG.6, the energy storage converter 14 can be supported on the support frame 1153 and abut against one side of the wall of the converter chamber 115.

When the energy storage converter 14 is directly supported on the bottom of the converter chamber 115, the pressure of the energy storage converter 14 on the bottom of the converter chamber 115 can be smaller, so as to facilitate the reduction of the structural strength requirements of the bottom of the converter chamber 115. When the energy storage converter 14 is supported on the support frame 1153, a gap can be defined a between the bottom of the energy storage converter 14 and the bottom of the converter 115, so as to facilitate the cold air cavity 1151 to cover the air inlet end of the energy storage converter 14, so as to effectively improve the heat-dissipation effect of the energy storage converter 14. When the energy storage converter 14 is placed in the middle of the converter chamber 115, a gap can be defined between the side of the energy storage converter 14 and the side wall of the converter chamber 115, so as to facilitate the cold air cavity 1151 to cover the air inlet end of the energy storage converter 14, thereby effectively improving the heat-dissipation effect of the energy storage converter 14. When the energy storage converter 14 abuts against the side wall of the converter chamber 115, the stability of the energy storage converter 14 assembled in the converter chamber 115 can be improved, and the shaking of the energy storage converter 14 in the converter chamber 115 can be reduced.

When the baffle 13 is set in the converter chamber 115, the baffle 13 can be set at the air outlet end of the energy storage converter 14, and most of the energy storage converter 14 is located in the cold air cavity 1151. Alternatively, a surface of the baffle 13 facing away from the air outlet 1121 can abut against the outlet end of the energy storage converter 14, to ensure that the energy storage converter 14 is entirely located in the cold air cavity 1151. In this way, the hot air got after the heat exchange with the energy storage converter 14 enters the hot air cavity 1152, and thus avoid the hot air affecting the heat-dissipation of the energy storage converter 14, thereby ensuring the heat-dissipation effect of the energy storage converter 14.

An outer contour edge of the baffle 13 abuts against the inner wall of the converter chamber 115, to ensure the sealing between the cold air cavity 1151 and the hot air cavity 1152. In addition, the outer contour edge of the baffle 13 can also be fixedly connected with the inner wall of the converter chamber 115 (such as welding), or the baffle 13 can be fixedly connected with a side wall or side walls of the energy storage converter 14.

For the case that the baffle 13 is set at the energy storage converter 14, it can be shown in FIG.8 that the baffle 13 has an avoidance opening 131, and edges of the avoidance opening 131 abut against the side walls of the air outlet end of the energy storage converter 14. For the case that the surface of the baffle 13 facing away from the outlet 1121 abuts against the outlet end of the energy storage converter 14, the baffle 13 can have the avoidance opening 131, the surface of the baffle 13 facing away from the outlet 1121 abuts against the outlet end of the energy storage converter 14, and the air outlet port 142 of the energy storage converter 14 is surround by the edges of the avoidance opening 131. In addition, for the case that the surface of the baffle 13 facing away from the outlet 1121 abuts against the outlet end of the energy storage converter 14, a gasket can also be set between the outlet end of the baffle 13 and the energy storage converter 14 to effectively avoid the hot air leakage from the hot air cavity 1152 to the cold air cavity 1151.

Further, for the avoidance opening 131 mentioned above, combined with the assembly position of the energy storage converter 14 in the converter chamber 115, when the energy storage converter 14 abuts against a side wall of the converter chamber 115, as shown in FIG.8, the avoidance opening 131 in the baffle 13 can be a rectangular notch at one side edge. When the energy storage converter 14 is supported on the support frame 1153 and placed in the middle, the avoidance opening 131 in the baffle 13 can be a rectangular through hole.

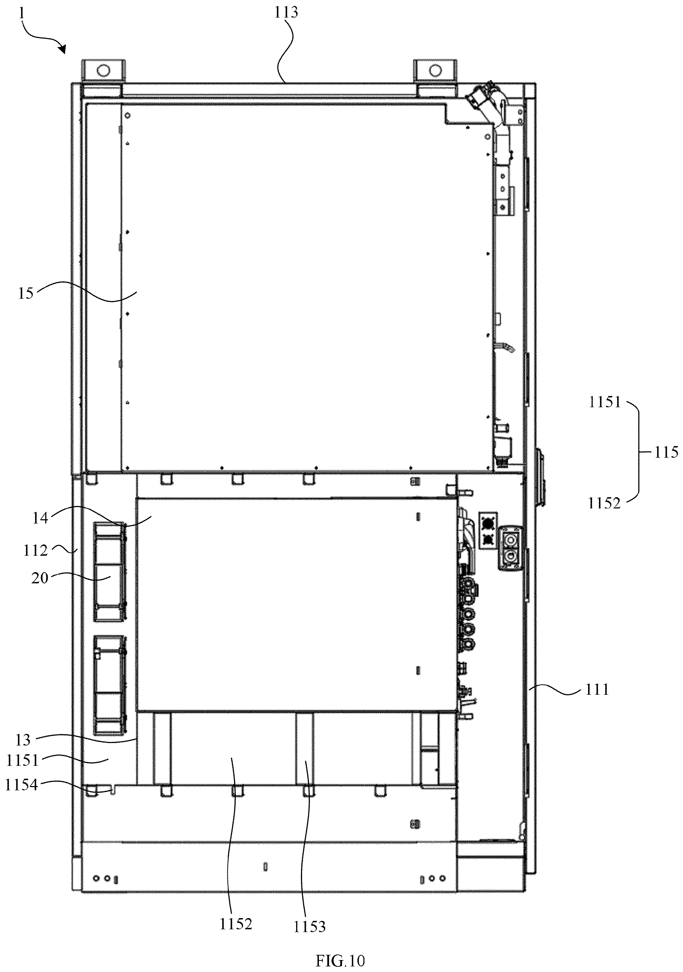

In the implementation of this application, the baffle 13 arranged in the converter chamber 115 can be a plate-like structure parallel to the back side plate 112 of the cabinet body 11 as shown in FIG.10, or can be a bent structure as shown in FIG.7 or FIG.8.

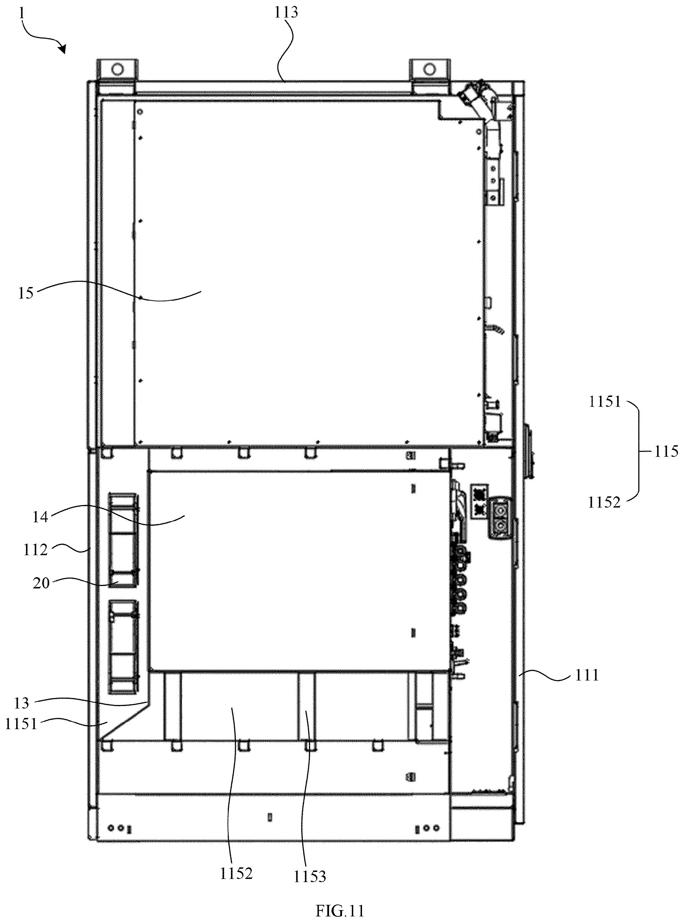

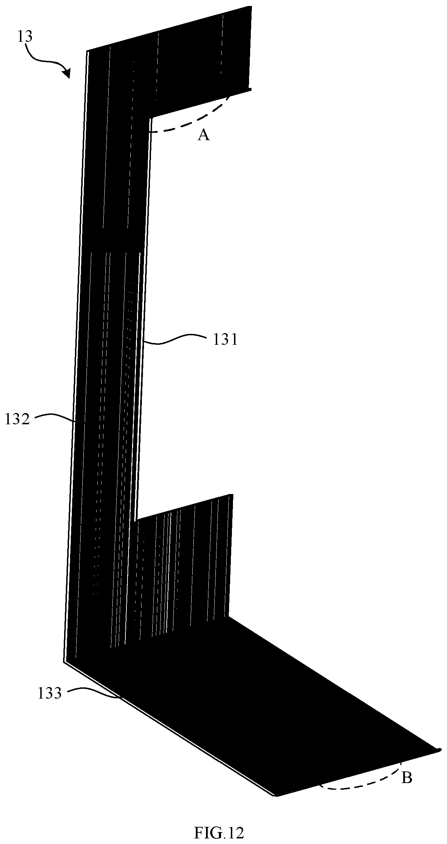

For the baffle 13 with the bent structure, as shown in FIG.11 and FIG.12, the baffle 13 includes a windshield part 132 and a guide part 133. The avoidance opening 131 is located in the windshield part 132. The guide part 133 is connected with the windshield part 132, and the edge of the guide part 133 away from the windshield part 132 faces towards the air outlet 1121 and abuts against the side plate (back side plate 112) of the cabinet body 11 having the air outlet 1121.

For the avoidance opening 131 in the windshield part 132, the edges of the avoidance opening 131 abut against the side walls of the outlet end of the energy storage converter 14; or the surface of the baffle 13 facing away from the air outlet 1121 abuts against the air outlet end of the energy storage converter 14, and the air outlet port 142 of the energy storage converter 14 is surround by the edges of the avoidance opening 131.

In this way, the hot air flows out from the air outlet port 142 of the energy storage converter 14, enters the hot air cavity 1152, and then can be gathered at the air outlet 1121 in the back side plate 112 under the guidance of the flow guide part 133, and further then flow out the hot air cavity 1152 from the air outlet 1121, thereby reducing a retention time of the hot air in the hot air cavity 1152. Thus, it is convenient to increase the inlet air volume of cold air and improve the cooling effect on the energy storage converter 14.

When the edge of the guide part 133 away from the wind shield part 132 abuts against the back side plate 112 of the cabinet body 11, the edge of the guide part 133 away from the wind shield part 132 is at least flush with the lowest position of the air outlet hole in the back side plate 112, so that the hot air in the hot air cavity 1152 can directly flow out of the hot air cavity 1152 from the air outlet 1121 under the guidance of the guide part 133.

Further, as shown in FIG.10 or FIG.11, the energy storage cabinet 1 further includes an axial flow fan 20, which is fixed in the hot air cavity 1152. The air inlet side of the axial flow fan 20 faces towards the air outlet port 142, and the air outlet side of the axial flow fan 20 faces toward the air outlet 1121. In this way, the hot air in the hot air cavity 1152 can be driven by the axial flow fan 20 to flow out of the hot air cavity 1152 faster, so as to increase the flow rate of cold air into the cold air cavity 1151, thus improving the cooling effect on the energy storage converter 14.

Optionally, the axial flow fan 20 is fixed on the side plate of the cabinet body 11 having the air outlet 1121, that is, the axial flow fan 20 is fixed on the back side plate 112 of the cabinet body 11, thus simplifying the installation of the axial flow fan 20 in the converter chamber 115. In addition, when the axial flow fan 20 is fixed on the back side plate 112 of the cabinet body 11, an air outlet side of the axial flow fan 20 directly coincides with the air outlet 1121 of the converter chamber 115, so that the hot air can directly flow out of the converter chamber 115 from the air outlet 1121 under the action of the axial flow fan 20, so as to reduce the airflow resistance of the back side plate 112 of the cabinet body 11 to the hot air.

In the implementation of this application, taking into account the operating environment of energy storage cabinet 1 (usually in the outdoors), in case of rain weather, the rainwater easily enter the converter chamber 115 from the air outlet 1121 in the back side plate 112, thus increasing the safety hazard. The baffle 13 mentioned above can block the rainwater entering the converter chamber 115 to keep the rainwater in the hot air cavity 1152 to avoid the impact of rain on the energy storage converter 14, thus improving the safety performance of the energy storage cabinet 1.

For the rainwater gathered in the hot air cavity 1152, combined with the above mentioned, as shown in FIG.10, when the baffle 13 is a plate-like structure (the plane of which is parallel to the back side plate 112), the rainwater will gather at the bottom wall of the hot air cavity 1152. The support frame 1153 is arranged in the converter chamber 115 and the energy storage converter 14 is supported on the support frame 1153, thus the normal operation of the energy storage converter will not be affected as long as the height of the rainwater is lower than that of the support frame 1153.

Further, in order to avoid the retention of rainwater in the hot air cavity 1152, as shown in FIG.10, the bottom wall of the hot air cavity 1152 is provided with a drainage hole 1154, so as to exhaust the rainwater gathered in the hot air cavity 1152 through the drainage hole 1154, thereby avoiding the problem of high humidity caused by long-term water accumulation in the hot air cavity 1152.

A drainage tube can be arranged at the drainage hole 1154, and one end of the drainage tube extends out of the cabinet body 11 to discharge the rainwater gathered in the hot air cavity 1152.

When the baffle 13 is a bent structure, the rainwater flowing along the back side plate 112 and then entering the converter chamber 115 can be gathered in the hot air cavity 1152 under the action of baffle 13, and then can flow out of the hot air cavity 1152 from the upper outlet 1121 of the back side plate 112 under the guiding action of the guide part 133, so as to avoid the retention of rainwater in the hot air cavity 1152, thereby further ensuring the safety of the operating environment of the energy storage converter 14 and reducing the potential safety hazard.

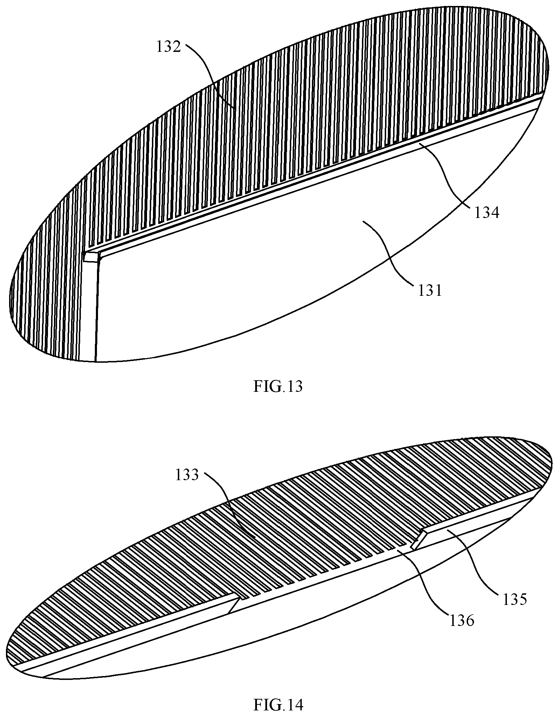

In the implementation of this application, when baffle 13 is reused as a rainwater baffle, in order to avoid rainwater retained on baffle 13 from flowing to the end face of the air outlet of the energy storage converter 14 along the edge of the avoidance opening 131 and then entering the energy storage converter 14 from the air outlet port 142, as shown in FIG.12 and FIG.13, the edge of the avoidance opening 131 has a first turning edge 134, and the first turning edge 134 tilts away from the energy storage converter 14. In this way, the retained rainwater on the baffle 13 flows on the surface of the baffle 13, and can bypass the avoidance opening 131 in the baffle 13 under the block of the first turning edge 134, so as to avoid the rainwater entering the energy storage converter 14 from the air outlet port 142, thus improving the safety of the operation of the energy storage converter 14.

The first turning edge 134 can be arranged at the upper edge of the avoidance opening 131, or can be arranged at the entire edge of the avoidance opening 131, as long as the rainwater on the baffle 13 can be prevented from entering the energy storage converter 14 from the avoidance opening 131.

Optionally, for the first turning edge 134 at the upper edge of the avoidance opening 131, the slope of the first turning edge 134 along the length direction of the upper edge can be set to be equal to 2 degrees, or greater than 2 degrees and less than 5 degrees. In this way, the rainwater gathered at the corner where the first turning edge 134 meets the upper edge of the avoidance opening 131 is easier to bypass the avoidance opening 131 in the baffle 13 along the first turning edge 134, so as to avoid the rainwater entering the energy storage converter 14 from the air outlet port 142 more easily. For example, the slope of the first turning edge 134 at the upper edge of the avoidance opening 131 along the length direction of the upper edge is 2 degrees, 3 degrees, 4 degrees, or 5 degrees. In addition, the first turning edge 134 at the upper edge of the avoidance opening 131 can be set to tilt along a direction of away from the avoidance opening 131. That is, an angle formed by the first turning edge 134 and the baffle 13 is an acute angle, so as to avoid the rainwater gathered at the corner where the first turning edge 134 meets the upper edge of the avoidance opening 131 from flowing past the first turning edge 134 and then entering the energy storage converter 14, thereby avoiding the rainwater from entering the energy storage converter 14 from the air outlet port 142.

For the rainwater falling on baffle 13 from the air outlet 1121 in the back side plate112, in addition to the first turning edge134 at the edge of the avoidance opening 131, a second turning edge 135 can also be arranged on the outer contour edge of baffle 13 facing away from the energy storage converter 14, to prevent the rainwater on the baffle 13 from entering the cold air cavity 1151 along a gap between the baffle 13 and the wall of the converter chamber 115 through the setting of the second turning edge 135.

Taking the baffle 13 having a bent structure as an example, the guide part 133 of the baffle 13, as shown in FIG.12 and FIG.14, has a second turning edge 135 at an edge of the guide part 133 away from the windshield part 132. The second turning edge 135 tilts away from the energy storage converter 14, and defines a gap 136 directly opposite to the air outlet 1121 in the back side plate 112. In this way, the rainwater gathered at the bottom wall of the hot air cavity 1152 can flow out of the hot air cavity 1152 from the gap 136 in the second turning edge 135 and the air outlet 1121 in the back side plate 112 under the action of the second turning edge 135, so as to avoid the retention of rainwater in the hot air cavity 1152, thus improving the stability of the energy storage converter 14 in the converter chamber 115.

The slope of the second turning edge 135 at both sides of the gap 136 along the length direction of the turning edge 135 is equal to 2 degrees, or greater than 2 degrees and less than 5 degrees. As such, the rainwater gathered at the bottom of guide part 133 is more likely to flow along the second turn edge 135 to the position of gap 136. For example, the slope of the second turning edge 135 on either sides of the gap 136 in the length direction can be 2 degrees, 3 degrees, 4 degrees, or 5 degrees.

Optionally, both side edges of the guide part 133 also have a third turning edge connected with the second turning edge 135, so that the rainwater falling on the guide part 133 can be avoided from entering the cold air cavity 1151 under the obstruction of the third turning edge, thereby avoiding the situation of water accumulation in the cold air cavity 1151. At the same time, because the third turning edge blocks the rainwater, it is convenient for the rainwater on the guide part 133 to quickly converge at the bottom wall of the hot air cavity 1152, thereby improving the outflow speed of the rainwater in the hot air cavity 1152.

Further, the surface of baffle 13 facing away from the energy storage converter 14 has guide grooves extending along the height direction of the cabinet body 11. Thus, under the drainage action of the guide grooves, the rainwater on the baffle 13 can smoothly gather at the bottom wall of the hot air cavity 1152, thus preventing the rainwater from entering the energy storage converter 14 from the air outlet port 142 of the energy storage converter 14 and from entering the cold air cavity 1151 along the outer contour edge of the baffle 13, thereby avoiding affecting the safety of the operation of the energy storage converter 14.

Taking the baffle 13 having a bent structure as an example, for the baffle 13 including the windshield part 132 and the guide part 133, the surface of the windshield part 132 facing away from the energy storage converter 14 and the surface of the guide part 133 facing away from the energy storage converter 14 each have guide grooves. The guide grooves provided by the windshield part 132 extend to the guide part 133. The guide grooves provided by the guide part 133 extend to the edge of the guide part 133 away from the windshield part 132. In this way, under the drainage action of the guide grooves, the rainwater falling on the windshield part 132 and the guide part 133 can be quickly gathered at the edge of the guide part 133 away from the windshield part 132, and then flow out the hot air cavity 1152 from the gap 136 in the second turning edge 135 and the air outlet 1121 in the back side plate 112, to avoid the retention of rain in the hot air cavity 1152.

In the embodiment of the present application, the terms "first", "second", and "third" are only used for descriptive purposes and cannot be understood as indicating or implying relative importance. The term "a plurality of" refers to two or more, unless otherwise specified. The terms "install", "communication ", "connection", "fix" and other terms may be broadly understood, for example, "connection" can be a fixed connection, a detachable connection, or an integrated connection; "communication" can be directly connected or indirectly connected through intermediate media. For persons of ordinary skill in the art, the specific meaning of the above terms in the embodiment of this application may be understood according to the specific circumstances.

In the description of the embodiment of the present application, it may be understood that, the orientation or position relationship indicated by the terms "up", "down", "left", "right", "front", "back", etc., is the orientation or position relationship shown based on the drawings, which is only for the convenience of describing the present application and simplifying the description, rather than indicating or implying that the apparatus or unit referred to must have a specific direction, be constructed and operated in a specific orientation. Therefore, it cannot be understood as a limitation on the present application,

In the description of this specification, the terms "one embodiment", "some embodiments", "specific embodiments", etc., refer to the specific features, structures, materials, or features described in conjunction with the embodiment or example being included in at least one embodiment or example of the present application. In this specification, the illustrative expressions of the above terms may not necessarily refer to the same embodiments or examples. Moreover, the specific features, structures, materials, or features described can be combined in an appropriate manner in any one or more embodiments or examples.

The above are only preferred embodiments of the present application and are not intended to limit the present application, for persons of ordinary skill in the art, the present application may have various modifications and variations. Any modification, equivalent replacement, improvement, etc. made within principles of the implementation of this application shall be included in the scope of protection of the implementation of this application.

## Claims

1. An energy storage cabinet (1), comprising:
a cabinet body (11), a partition (12) being provided in the cabinet body (11), an internal space of the cabinet body (11) comprising a battery chamber (114) and a converter chamber (115) separated by the partition (12), side plates of the cabinet body (11) having an air inlet (1111) and an air outlet (1121) respectively, and the air inlet (1111) and the air outlet (1121) being in communication with the converter chamber (115);
a baffle (13), located in the converter chamber (115) and separating the converter chamber (115) into a cold air cavity (1151) and a hot air cavity (1152), the cold air cavity (1151) being in communication with the air inlet (1111), and the hot air cavity (1152) being in communication with the air outlet (1121); and
an energy storage converter (14), located in the converter chamber (115) and having a heat-dissipation air duct, the heat-dissipation air duct comprising an air inlet port (141) being located at an air inlet end of the energy storage converter (14) and an air outlet port (142) being located at an air outlet end of the energy storage converter (14), the air inlet port (141) being in communication with the cold air cavity (1151), and the air outlet port (142) being in communication with the hot air cavity (1152),
wherein the baffle (13) has an avoidance opening (131), an edge of the avoidance opening (131) abuts against a side wall of the air outlet end of the energy storage converter (14),
**characterized in that** the baffle (13) comprises a windshield part (132) and a guide part (133);
the avoidance opening (131) is located in the windshield part (132), the guide part (133) is connected with the windshield part (132), and an edge of the guide part (133) away from the windshield part (132) faces towards the air outlet (1121) and abuts against one of the side plates of the cabinet body (11) having the air outlet (1121).

2. The energy storage cabinet (1) of claim 1, wherein the energy storage cabinet further comprises an axial flow fan (20) fixed in the hot air cavity (1152), an air inlet side of the axial flow fan (20) faces toward the air outlet port (142), and an air outlet side of the axial flow fan (20) faces toward the air outlet (1121).

3. The energy storage cabinet (1) of claim 2, wherein the axial flow fan (20) is fixed on said one of the side plates of the cabinet body (11) having the air outlet (1121).

4. The energy storage cabinet (1) of claim 1, wherein the edge of the avoidance opening (131) has a first turning edge (134), the first turning edge (134) tilts away from the energy storage converter (14).

5. The energy storage cabinet (1) of claim 4, wherein a slope of the first turning edge (134) at an upper edge of the avoidance opening (131) along a length direction of the upper edge is equal to 2 degrees, or greater than 2 degrees and less than 5 degrees.

6. The energy storage cabinet (1) of claim 4, wherein an edge of the guide part (133) away from the windshield part (132) has a second turning edge (135), the second turning edge (135) tilts away from the energy storage converter (14), and the second turning edge (135) defines a gap (136) directly opposite to the air outlet (1121).

7. The energy storage cabinet (1) of any one of claims 4 to 6, wherein a surface of the windshield part (132) facing away from the energy storage converter (14) and a surface of the guide part (133) facing away from the energy storage converter (14) each have guide grooves, the guide grooves provided by the windshield part (132) extend to the guide part (133), the guide grooves provided by the guide part (133) extend to an edge of the guide part (133) away from the windshield part (132).

8. The energy storage cabinet (1) of claim 1, wherein the baffle (13) is a plate-like structure, a bottom wall of the hot air cavity (1152) is provided with a drainage hole (1154), a support frame (1153) is arranged in the converter chamber (115), the energy storage converter (14) is supported on the support frame (1153).

9. The energy storage cabinet (1) of claim 1, wherein the internal space of the cabinet body (11) further comprises a liquid cooling chamber (116) separated by the partition (12); and
the energy storage cabinet (1) further comprises a liquid cooling unit (15) and a liquid cooling pipeline (1141), the liquid cooling unit (15) is located in the liquid cooling chamber (116), the liquid cooling pipeline (1141) is located in the battery chamber (114) and is in communication with the liquid cooling unit (15).

10. A cabinet-type energy storage device (10), comprising:
the energy storage cabinet (1) according to claim 1; and
a storage rack arranged in the battery chamber (114);
an energy storage unit (2) located on the storage rack and electrically connected with the energy storage converter (14).

11. The cabinet-type energy storage device (10) of claim 10, wherein the baffle (13) has an avoidance opening (131), an edge of the avoidance opening (131) abuts against a side wall of the air outlet end of the energy storage converter (14).

12. The cabinet-type energy storage device (10) of claim 10 or 11, wherein the energy storage cabinet further comprises an axial flow fan (20) fixed in the hot air cavity (1152), an air inlet side of the axial flow fan (20) faces toward the air outlet port (142), and an air outlet side of the axial flow fan (20) faces toward the air outlet (1121).

13. The energy storage cabinet (1) of claim 11, wherein the baffle (13) is a plate-like structure, a bottom wall of the hot air cavity (1152) is provided with a drainage hole (1154), a support frame (1153) is arranged in the converter chamber (115), the energy storage converter (14) is supported on the support frame (1153).

## Patentansprüche

1. Energiespeicherschrank (1), umfassend:
einen Schrankkörper (11), wobei in dem Schrankkörper (11) eine Trennwand (12) vorgesehen ist, wobei ein Innenraum des Schrankkörpers (11) eine Batteriekammer (114) und eine Umrichterkammer (115) umfasst, die durch die Trennwand (12) voneinander getrennt sind, wobei die Seitenplatten des Schrankkörpers (11) jeweils einen Lufteinlass (1111) bzw. einen Luftauslass (1121) aufweisen und der Lufteinlass (1111) und der Luftauslass (1121) mit der Umrichterkammer (115) in Verbindung stehen;
ein Leitblech (13), das in der Umrichterkammer (115) angeordnet ist und die Umrichterkammer (115) in einen Kaltlufthohlraum (1151) und einen Warmlufthohlraum (1152) unterteilt, wobei der Kaltlufthohlraum (1151) mit dem Lufteinlass (1111) in Verbindung steht und der Warmlufthohlraum (1152) mit dem Luftauslass (1121) in Verbindung steht; und
einen Energiespeicherumrichter (14), der in der Umrichterkammer (115) angeordnet ist und einen Wärmeableitungsluftkanal aufweist, wobei der Wärmeableitungsluftkanal eine Lufteinlassöffnung (141), die an einem Lufteinlassende des Energiespeicherumrichters (14) angeordnet ist, und eine Luftauslassöffnung (142), die an einem Luftauslassende des Energiespeicherumrichters (14) angeordnet ist, umfasst, wobei die Lufteinlassöffnung (141) mit dem Kaltlufthohlraum (1151) in Verbindung steht und die Luftauslassöffnung (142) mit dem Warmlufthohlraum (1152) in Verbindung steht,
wobei das Leitblech (13) eine Freistellungsöffnung (131) aufweist und ein Rand der Freistellungsöffnung (131) an einer Seitenwand des Luftauslassendes des Energiespeicherumrichters (14) anliegt,
**dadurch gekennzeichnet, dass** das Leitblech (13) einen Luftabschirmabschnitt (132) und einen Führungsabschnitt (133) umfasst;
wobei die Freistellungsöffnung (131) in dem Luftabschirmabschnitt (132) angeordnet ist, der Führungsabschnitt (133) mit dem Luftabschirmabschnitt (132) verbunden ist und ein von dem Luftabschirmabschnitt (132) abgewandter Rand des Führungsabschnitts (133) dem Luftauslass (1121) zugewandt ist und an einer Seitenplatte des Schrankkörpers (11), die den Luftauslass (1121) aufweist, anliegt.

2. Energiespeicherschrank (1) nach Anspruch 1, wobei der Energiespeicherschrank ferner einen in dem Warmlufthohlraum (1152) befestigten Axiallüfter (20) umfasst, wobei eine Lufteinlassseite des Axiallüfters (20) der Luftauslassöffnung (142) zugewandt ist und eine Luftauslassseite des Axiallüfters (20) dem Luftauslass (1121) zugewandt ist.

3. Energiespeicherschrank (1) nach Anspruch 2, wobei der Axiallüfter (20) an derjenigen Seitenplatte des Schrankkörpers (11) befestigt ist, die den Luftauslass (1121) aufweist.

4. Energiespeicherschrank (1) nach Anspruch 1, wobei der Rand der Freistellungsöffnung (131) eine erste Abkantung (134) aufweist und die erste Abkantung (134) von dem Energiespeicherumrichter (14) weg geneigt ist.

5. Energiespeicherschrank (1) nach Anspruch 4, wobei der Neigungswinkel der ersten Abkantung (134) am oberen Rand der Freistellungsöffnung (131) in Längsrichtung des oberen Randes 2 Grad beträgt oder größer als 2 Grad und kleiner als 5 Grad ist.

6. Energiespeicherschrank (1) nach Anspruch 4, wobei ein von dem Luftabschirmabschnitt (132) abgewandter Rand des Führungsabschnitts (133) eine zweite Abkantung (135) aufweist, wobei die zweite Abkantung (135) von dem Energiespeicherumrichter (14) weg geneigt ist und die zweite Abkantung (135) einen dem Luftauslass (1121) unmittelbar gegenüberliegenden Spalt (136) begrenzt.

7. Energiespeicherschrank (1) nach einem der Ansprüche 4 bis 6, wobei eine von dem Energiespeicherumrichter (14) abgewandte Oberfläche des Luftabschirmabschnitts (132) und eine von dem Energiespeicherumrichter (14) abgewandte Oberfläche des Führungsabschnitts (133) jeweils Führungsnuten aufweisen, wobei sich die an dem Luftabschirmabschnitt (132) ausgebildeten Führungsnuten bis zu dem Führungsabschnitt (133) erstrecken und sich die an dem Führungsabschnitt (133) ausgebildeten Führungsnuten bis zu einem von dem Luftabschirmabschnitt (132) abgewandten Rand des Führungsabschnitts (133) erstrecken.

8. Energiespeicherschrank (1) nach Anspruch 1, wobei das Leitblech (13) plattenförmig ausgebildet ist, eine Bodenwand des Warmlufthohlraums (1152) mit einer Entwässerungsöffnung (1154) versehen ist, ein Stützrahmen (1153) in der Umrichterkammer (115) angeordnet ist und der Energiespeicherumrichter (14) auf dem Stützrahmen (1153) abgestützt ist.

9. Energiespeicherschrank (1) nach Anspruch 1, wobei der Innenraum des Schrankkörpers (11) ferner eine durch die Trennwand (12) abgetrennte Flüssigkeitskühlkammer (116) umfasst;
und der Energiespeicherschrank (1) ferner eine Flüssigkeitskühleinheit (15) und eine Flüssigkeitskühlleitung (1141) umfasst, wobei die Flüssigkeitskühleinheit (15) in der Flüssigkeitskühlkammer (116) angeordnet ist und die Flüssigkeitskühlleitung (1141) in der Batteriekammer (114) angeordnet ist und mit der Flüssigkeitskühleinheit (15) in Verbindung steht.

10. Schrankartige Energiespeichervorrichtung (10), umfassend:
den Energiespeicherschrank (1) nach Anspruch 1;
ein in der Batteriekammer (114) angeordnetes Speichergestell; und
eine auf dem Speichergestell angeordnete und mit dem Energiespeicherumrichter (14) elektrisch verbundene Energiespeichereinheit (2).

11. Schrankartige Energiespeichervorrichtung (10) nach Anspruch 10, wobei das Leitblech (13) eine Freistellungsöffnung (131) aufweist und ein Rand der Freistellungsöffnung (131) an einer Seitenwand des Luftauslassendes des Energiespeicherumrichters (14) anliegt.

12. Schrankartige Energiespeichervorrichtung (10) nach Anspruch 10 oder 11, wobei der Energiespeicherschrank ferner einen in dem Warmlufthohlraum (1152) befestigten Axiallüfter (20) umfasst, wobei eine Lufteinlassseite des Axiallüfters (20) der Luftauslassöffnung (142) zugewandt ist und eine Luftauslassseite des Axiallüfters (20) dem Luftauslass (1121) zugewandt ist.

13. Energiespeicherschrank (1) nach Anspruch 11, wobei das Leitblech (13) plattenförmig ausgebildet ist, eine Bodenwand des Warmlufthohlraums (1152) mit einer Entwässerungsöffnung (1154) versehen ist, ein Stützrahmen (1153) in der Umrichterkammer (115) angeordnet ist und der Energiespeicherumrichter (14) auf dem Stützrahmen (1153) abgestützt ist.

## Revendications

1. Armoire de stockage d'énergie (1), comprenant :
un corps d'armoire (11), une cloison (12) étant prévue dans le corps d'armoire (11), un espace interne du corps d'armoire (11) comprenant une chambre de batterie (114) et une chambre de convertisseur (115) séparées par la cloison (12), des plaques latérales du corps d'armoire (11) ayant une entrée d'air (1111) et une sortie d'air (1121) respectivement, et l'entrée d'air (1111) et la sortie d'air (1121) étant en communication avec la chambre de convertisseur (115) ;
un déflecteur (13), situé dans la chambre de convertisseur (115) et séparant la chambre de convertisseur (115) en une cavité d'air froid (1151) et une cavité d'air chaud (1152), la cavité d'air froid (1151) étant en communication avec l'entrée d'air (1111), et la cavité d'air chaud (1152) étant en communication avec la sortie d'air (1121) ; et
un convertisseur de stockage d'énergie (14), situé dans la chambre de convertisseur (115) et ayant un conduit d'air de dissipation thermique, le conduit d'air de dissipation thermique comprenant un orifice d'entrée d'air (141) étant situé à une extrémité d'entrée d'air du convertisseur de stockage d'énergie (14) et un orifice de sortie d'air (142) étant situé à une extrémité de sortie d'air du convertisseur de stockage d'énergie (14), l'orifice d'entrée d'air (141) étant en communication avec la cavité d'air froid (1151), et l'orifice de sortie d'air (142) étant en communication avec la cavité d'air chaud (1152),
dans laquelle le déflecteur (13) a une ouverture d'évitement (131), un bord de l'ouverture d'évitement (131) bute contre une paroi latérale de l'extrémité de sortie d'air du convertisseur de stockage d'énergie (14),
**caractérisée en ce que** le déflecteur (13) comprend une partie pare-vent (132) et une partie de guidage (133) ;
l'ouverture d'évitement (131) est située dans la partie pare-vent (132), la partie de guidage (133) est reliée à la partie pare-vent (132), et un bord de la partie de guidage (133) éloigné de la partie pare-vent (132) fait face à la sortie d'air (1121) et bute contre l'une des plaques latérales du corps d'armoire (11) ayant la sortie d'air (1121).

2. Armoire de stockage d'énergie (1) selon la revendication 1, dans laquelle l'armoire de stockage d'énergie comprend en outre un ventilateur axial (20) fixé dans la cavité d'air chaud (1152), un côté d'entrée d'air du ventilateur axial (20) fait face à l'orifice de sortie d'air (142), et un côté de sortie d'air du ventilateur axial (20) fait face à la sortie d'air (1121).

3. Armoire de stockage d'énergie (1) selon la revendication 2, dans laquelle le ventilateur axial (20) est fixé sur ladite une des plaques latérales du corps d'armoire (11) ayant la sortie d'air (1121).

4. Armoire de stockage d'énergie (1) selon la revendication 1, dans laquelle le bord de l'ouverture d'évitement (131) a un premier bord de retournement (134), le premier bord de retournement (134) s'incline en s'éloignant du convertisseur de stockage d'énergie (14).

5. Armoire de stockage d'énergie (1) selon la revendication 4, dans laquelle une inclinaison du premier bord de retournement (134) au niveau d'un bord supérieur de l'ouverture d'évitement (131) le long d'une direction de longueur du bord supérieur est égale à 2 degrés, ou supérieure à 2 degrés et inférieure à 5 degrés.

6. Armoire de stockage d'énergie (1) selon la revendication 4, dans laquelle un bord de la partie de guidage (133) éloigné de la partie pare-vent (132) a un deuxième bord de retournement (135), le deuxième bord de retournement (135) s'incline en s'éloignant du convertisseur de stockage d'énergie (14), et le deuxième bord de retournement (135) définit un espace (136) directement opposé à la sortie d'air (1121).

7. Armoire de stockage d'énergie (1) selon l'une quelconque des revendications 4 à 6, dans laquelle une surface de la partie pare-vent (132) orientée à l'opposé du convertisseur de stockage d'énergie (14) et une surface de la partie de guidage (133) orientée à l'opposé du convertisseur de stockage d'énergie (14) ont chacune des rainures de guidage, les rainures de guidage fournies par la partie pare-vent (132) s'étendent jusqu'à la partie de guidage (133), les rainures de guidage fournies par la partie de guidage (133) s'étendent jusqu'à un bord de la partie de guidage (133) éloigné de la partie pare-vent (132).

8. Armoire de stockage d'énergie (1) selon la revendication 1, dans laquelle le déflecteur (13) est une structure en forme de plaque, une paroi inférieure de la cavité d'air chaud (1152) est pourvue d'un trou de drainage (1154), un cadre de support (1153) est agencé dans la chambre de convertisseur (115), le convertisseur de stockage d'énergie (14) est supporté sur le cadre de support (1153).

9. Armoire de stockage d'énergie (1) selon la revendication 1, dans laquelle l'espace interne du corps d'armoire (11) comprend en outre une chambre de refroidissement par liquide (116) séparée par la cloison (12) ; et
l'armoire de stockage d'énergie (1) comprend en outre une unité de refroidissement par liquide (15) et une conduite de refroidissement par liquide (1141), l'unité de refroidissement par liquide (15) est située dans la chambre de refroidissement par liquide (116), la conduite de refroidissement par liquide (1141) est située dans la chambre de batterie (114) et est en communication avec l'unité de refroidissement par liquide (15).

10. Dispositif de stockage d'énergie de type armoire (10), comprenant :
l'armoire de stockage d'énergie (1) selon la revendication 1 ; et
un rack de stockage agencé dans la chambre de batterie (114) ;
une unité de stockage d'énergie (2) située sur le rack de stockage et connectée électriquement au convertisseur de stockage d'énergie (14).

11. Dispositif de stockage d'énergie de type armoire (10) selon la revendication 10, dans lequel le déflecteur (13) a une ouverture d'évitement (131), un bord de l'ouverture d'évitement (131) bute contre une paroi latérale de l'extrémité de sortie d'air du convertisseur de stockage d'énergie (14).

12. Dispositif de stockage d'énergie de type armoire (10) selon la revendication 10 ou 11, dans lequel l'armoire de stockage d'énergie comprend en outre un ventilateur axial (20) fixé dans la cavité d'air chaud (1152), un côté d'entrée d'air du ventilateur axial (20) fait face à l'orifice de sortie d'air (142), et un côté de sortie d'air du ventilateur axial (20) fait face à la sortie d'air (1121).

13. Armoire de stockage d'énergie (1) selon la revendication 11, dans laquelle le déflecteur (13) est une structure en forme de plaque, une paroi inférieure de la cavité d'air chaud (1152) est pourvue d'un trou de drainage (1154), un cadre de support (1153) est agencé dans la chambre de convertisseur (115), le convertisseur de stockage d'énergie (14) est supporté sur le cadre de support (1153).
